# EUROPEAN PATENT APPLICATION

(11) **EP 2 645 428 A1**
(43) Date of publication of application: **02.10.2013**
(21) Application number: 12290106.9
(22) Date of filing: 28.03.2012
(51) Int. Cl.: H01L 31/18, H01L 31/0687, H01L 31/0304, H01L 21/18, H01L 21/762, C30B 33/06, H01L 21/20

(54) **Manufacture of multijuntion solar cell devices**

(71) Applicant: Soitec, 38190 Bernin (FR); Fraunhofer-Gesellschaft zur Förderung der angewandten Forschung e.V., 80686 München (DE)
(72) Inventor: Ghyselen, Bruno, 38170 Seyssinet (FR); Arena, Chantal, 82505 Mesa AZ (US); Dimroth, Frank, 79115 Freiburg (DE); Bett, Andreas W., 79114 Freiburg (DE)
(74) Representative: Grünecker, Kinkeldey, Stockmair & Schwanhäusser

(57) **Abstract**

The present invention relates to a method for manufacturing a multijunction solar cell device comprising the steps of providing a first substrate; providing a second substrate having a lower surface and an upper surface; forming at least one first solar cell layer on the first substrate to obtain a first wafer structure; forming at least one second solar cell layer on the upper surface of the second substrate to obtain a second wafer structure; bonding the first wafer structure to the second wafer structure wherein the at least one first solar cell layer is bonded to the lower surface of the second substrate and removing the first substrate.

## Description

### Field of Invention

The present invention relates to the manufacture of multijunction solar cell substrates, in particular, to the manufacture of multijunction solar cell substrates comprising wafer transfer processes and the manufacture of solar cell devices for terrestrial and space-related applications.

### Background of the invention

Photovoltaic or solar cells are designed for converting the solar radiation to electrical current. In concentrator solar photovoltaic applications the incoming sun light is optically concentrated before it is directed to solar cells. For example, the incoming sun light is received by a primary mirror that reflects the received radiation toward a secondary mirror that, in turn, reflects the radiation toward a solar cell, which converts the concentrated radiation to electrical current by the generation of electronhole pairs in III-V semiconductor or single crystal silicon, for example. Alternatively, the sunlight could be concentrated onto solar cells by using transmittive optics like Fresnel lenses.

Since different semiconductor material composition show optimal absorption for different wavelengths of the incoming solar light, multijunction solar cells have been proposed that comprise, for example, three cells showing optimal absorption in different wavelength ranges. A triple cell structure may comprise a GaInP top cell layer with a gap value of 1.8 eV, a GaAs intermediate cell layer with a gap value of 1.4 eV and a Ge bottom cell layer with a gap value of 0.7 eV, for instance. In principle, III-V or group IV semiconductors can be used as active subcells of multijunction cell devices manufactured by layer transfer/bonding. Multijunction solar cells are usually manufactured by monolithic epitaxial growth. The monolithic growth process requires, in general, that any formed layers be substantially lattice matched to previously formed layers or the underlying substrate. However, the epitaxial growth of the solar cell layers on growth substrates still provides a demanding problem in view of lattice mismatches. For example, it is not suitable to epitaxially grow an InP solar cell layer on a Ge substrate, since the crystalline and optical characteristics of the InP solar cell layer would be heavily deteriorated due to crystal mismatch. In addition, in conventionally used transfer processes intermediate substrates are lost after the transfer of epitaxially grown layers.

Thus, despite the recent engineering progress there is still a need for an improved manufacturing process for multijunction solar cell devices wherein solar cell layers with a low defect rate are achieved and an intermediate substrate can be recycled.

### Description of the Invention

The present invention addresses the above-mentioned need and, accordingly, provides a method for manufacturing a multijunction solar cell device, comprising the steps of
providing a first substrate;
providing a second substrate having a lower surface and an upper surface;
forming at least one first solar cell layer on the first substrate to obtain a first wafer structure;
forming at least one second solar cell layer on the upper surface of the second substrate to obtain a second wafer structure;
bonding the first wafer structure to the second wafer structure wherein the at least one first solar cell layer is bonded to the lower surface of the second substrate; and removing / detaching the first substrate.

The resulting structure, thus, comprises at least one solar cell layer on either side (upper and lower surface, respectively) of the second substrate. Different from the art, the solar cell layers on either side of the second substrate are not all provided by epitaxial deposition, but also by bonding. Since the surfaces of the second substrate can be polished before bonding the bond can be achieved with high quality, in particular, with a better quality as compared to bonding at two (epitaxially grown) solar cell layers. The step of bonding the first wafer structure to the second wafer structure can be a high-temperature bonding performed at a temperature of about 400 °C to about 600 °C, particularly, between 450°C and 550°C, thereby allowing a reliable bond. The second substrate can be a relatively thin substrate of some 100 micrometers, for example, of about 200 micrometers and transparent to the some wavelengths of the incoming solar light, as it will be explained below. In particular, the second substrate can be made of or comprise GaAs.

The first substrate can be provided in form of an engineered substrate, in particular, comprising sapphire.

The term "engineered substrate" comprises a substrate that is different from a mere pure bulk substrate but rather includes a layer or interface that is formed in the substrate in order to facilitate its removal from the structure resulting of the bonding of the first and second wafer structures. In particular, the "engineered substrate" may comprise a zipper layer between a seed layer and a base substrate. In particular, the engineered substrate may comprise a base substrate that is detached from the seed layer in the step of removal of the engineered substrate.

Detachment by means of the zipper layer allows for recycling the detached substrate.

In the document, the expression "detachment of the engineered substrate" should be interpreted as the detachment of the base substrate. This detachment step may be followed by the removal of the possible residue of the zipper layer (if any), and of the removal of the seed layer from the remaining structure.

The zipper layer may be a weakened layer formed, e.g., by an appropriate treatment, for instance, a hydrogen or helium implantation in a substrate, that delimits an upper seed layer and a lower base substrate.

The zipper layer may be formed by a buried porous layer by anodic etching at a surface of the base substrate. Then epitaxial growth of the seed layer can be performed on top of the porous layer.

The zipper layer may be provided in form of an absorbing layer for laser lift-off, chemical lift off or mechanical splitting in an intermediate strained layer during an epitaxy sequence: SiGe in Si matrix, in particular, an intermediate strained layer of SiGe at 20% in a Si substrate. In this alternative, the zipper layer may be formed by the seed layer itself, for instance the seed layer can be selectively & chemically etched away to detach the engineered substrate.

The zipper layer may also be formed of a SiN absorbing layer for laser lift-off inserted between a seed layer and a transparent base substrate, as known for example from W02010015878.

Another possibility for an engineered substrate reads as follows: A removable (presenting a low bonding energy of less than 1.5 J/m², and preferentially less than 1J/m²) bonding interface is formed between facing surfaces of a seed layer and a base support. In that possibility, the zipper layer is formed by the removable bonding interface. A first solar cell layer may be grown by epitaxy on the seed layer while preserving the removable character of the bonding interface, with the engineered substrate being heated to an epitaxial growth temperature. The low energy bonding is obtained by performing a treatment for augmenting the roughness of the facing surface of one of the seed layer or the substrate in particular carried out by chemical attack or etching, by effecting a treatment for decreasing hydrophilicity of the facing surface of one of the seed layer or the substrate (or the bonding layer in SiO₂ or Si₃N₄ on each of them). Moreover, a different material for the bonding layer can be chosen such that weak intrinsic mutual chemical affinity of the interface materials is achieved. The detachment of the base substrate may be performed by application of a thermal treatment or mechanical stresses applied from a jet of fluid or a blade, for example. This is disclosed for instance in WO03/063214

As already mentioned, the engineered substrate includes a seed layer formed at the top of the zipper layer or removable bonding interface. The seed layer is transferred from the seed substrate to a base substrate by layer transfer from wafer to wafer, for example, by the Smart Cut^{™} process. The seed layer may contain or not an epitaxial layer that has been formed originally by epitaxy on the seed substrate. Alternatively, the seed layer has been transferred or detached from a bulk seed substrate. In a preferred embodiment of the present invention, the seed layer is not used as a solar cell layer but rather a first solar cell layer is grown on the seed layer.

The seed layer is not necessarily used as a part of a solar cell layer because its band gap may not be adapted for an optimal efficiency in the sequence of subcell layers Therefore, in an embodiment of the present invention the seed layer is only used for the growth of the first solar cell layer thereby resulting in a multijunction solar cell device comprising a first solar cell layer (as a bottom cell) with both satisfying crystal and electrical characteristics. In fact, according to the above example one might remove the seed layer, e.g., by chemical treatment as etching.

In the above-described examples the solar cell layers can be grown with high crystal and electrical quality. For example, a dislocation density of less than 10⁶ / cm² can be achieved.

The detachment at the zipper layer may be performed by laser lift-off: A laser beam is radiated to the engineered substrate, for example, comprising a sapphire substrate, and provokes the decomposition of the material in the zipper layer thereby allowing for detachment at the zipper layer.

Further, the method may comprise forming a contact on the at least one first solar cell layer after detachment of the first substrate and/or forming a contact on the at least one second solar cell layer. Furthermore, before forming a contact the corresponding solar cell layer may be patterned to form a mesa whereupon the contact can be provided.

The structure comprising the second substrate and at least one solar cell layer on either main surface of the same may be bonded to a base substrate. The bonding to the base substrate can be performed by means of an electrically conductive (metallic, or with conductor oxides, transparent conductor oxide TCO, silicide or by direct bonding, etc) bonding layer formed on the first solar cell layer and/or the base substrate. An electrically conductive layer particularly helps also to provide for thermal conductivity to the base substrate that may function as a heat sink or may be connected to a heat sink and preferably is itself thermally and electrically conductive. The conductive bonding may be obtained by forming an eutectic Au/Sn or by thermocompression.

In this embodiment bonding of the first and second wafer structure is performed while the (final) base substrate is not present in the structure. Thus, risk of metallic contaminations is avoided during bonding thermal treatment such that high temperature may be used. Moreover, the expansion of the base substrate that would be different from the expansion of the first and second substrate at such a temperature due to different coefficient of thermal expansion (CTE) would damage the structure, in particular it would weakened the bonding interface.

According to a particular variant, in the above-described examples, the at least one first solar cell layer comprises two layers, a first and a second layer, that have been grown by epitaxy on the first layer, and the at least one second solar cell layer also comprises two layers, namely a third and a fourth layer that has been grown by epitaxy on the third layer. According to a particular example, the first layer (bottom cell) comprises or consists of GaInAs and/or the second layer comprises or consists of GaInAsP and/or the fourth layer (top cell in the finished multijunction solar cell device) comprises or consists of GaInP and/or the third layer comprises or consists of GaAs. Thus, a four-cell multijunction solar cell device is achieved (comprising two solar cell layers on either main surface of the second substrate) wherein the material of each cell is optimized for a particular wavelength of the incoming solar light. The first and second solar cell layers are bonded to one side (main surface) of the second substrate whereas the third and fourth solar cell layers are grown on the other side (main surface) of the second substrate. No inversion of layers is necessary during the entire manufacturing process, i.e. each series of layers are grown in the final order on their respective substrates, second layer is grown over the first layer and the fourth layer is grown over the third layer.

It should be noted that in all of the above-described examples one single detachment step (detaching the first substrate) only is involved.

The present invention also provides an intermediate semiconductor device, comprising
a substrate, in particular, a GaAs substrate;
a second layer formed on a lower surface of the substrate, a first layer formed on the second solar cell layer, a third layer formed on an upper surface of the substrate and a fourth layer formed on the third layer wherein the first layer comprises or consists of GaInAs and/or the second layer comprises or consists of GaInAsP and/or the third layer comprises or consists of GaAs and/or the fourth layer comprises or consists of GaInP.

The intermediate semiconductor substrate according to an example further comprises a further substrate comprising InP, in particular, an engineered substrate comprising InP, in particular, InP on sapphire, whereupon the first solar cell layer is formed.

The intermediate semiconductor substrate may further comprise a base substrate, in particular, a base substrate made of Cu, Mo, W or Si or Al, in particular aluminium sheet bonded to the first solar cell layer, in particular, by a conductive bonding layer.

In addition, it is provided a multijunction solar cell device obtainable by one of the above-described examples of the method for the manufacture of a multijunction solar cell device according to the present invention.

Additional features and advantages of the present invention will be described with reference to the drawings. In the description, reference is made to the accompanying figure that is meant to illustrate an embodiment of the invention. It is understood that such an embodiment does not represent the full scope of the invention.

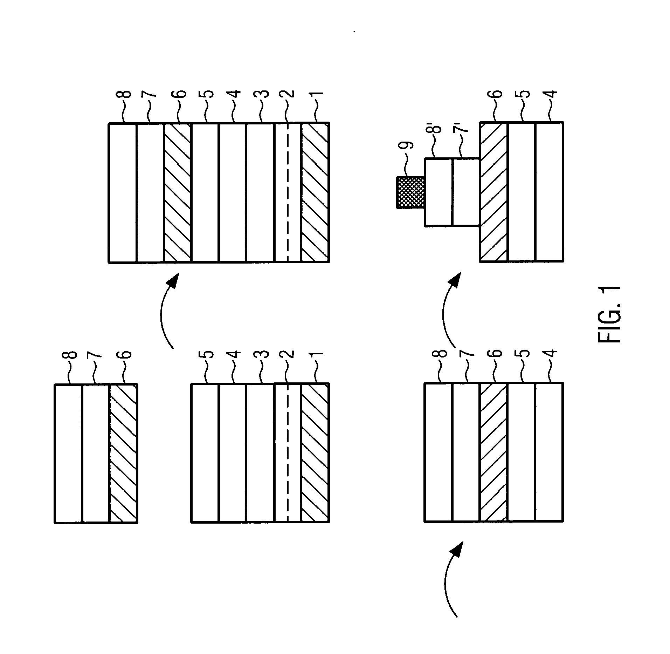

Figure 1 illustrates an example for the inventive method for the manufacturing of a multijunction solar cell comprising a wafer bonding step and a substrate detachment step.

An example for the inventive method for the manufacturing of a multijunction solar cell comprising four solar cell layers is shown in Figure 1. A first engineered base substrate comprising a zipper layer 2 for later detachment of the first base substrate 1 is provided. The term "engineered" generally refers to a substrate that is treated in a way to introduce some layer or interface within the substrate that facilitates detachment of the substrate after wafer bonding in a later processing step. For example, the first base substrate 1 is a sapphire substrate. Sapphire may preferably be chosen in view of its coefficient of thermal expansion which is of importance for the temperature change (up & down) during epitaxy and for the further processing, in particular, bonding step (see below). Moreover, sapphire is transparent to laser light and can, thus, allow for laser lift-off in a later processing step (see below). A seed layer 3, for example, an InP or GaAs seed layer is formed on the first base substrate 1. For example, the seed layer may be grown on a seed substrate and then be transferred to the engineered substrate.

In principle, the engineered substrate can be fabricated by means of layer transfer of the respective seed layers to the base substrates. For example, an InP epitaxial layer or as another example a strained or relaxed InGaAs layer may be the surface layer of an initial bulk InP seed substrate which is subsequently transferred to a sapphire substrate by the well-known Smart Cut^{™} process. The remainder of initial bulk seed substrate can be recycled after the transfer. The base substrates can also be recycled after the respective detachment steps. For forming an InP seed layer, it is preferable to apply the well known Smart Cut^{™} process onto a bulk InP seed substrate. Applying the same process onto an epitaxial stack composed of InP may be chosen however offering more options regarding for instance the choice of doping levels, crystalline quality and exact process to manufacture the seed layer 3.

The zipper layer 2 is comprised of SiN or the material of the seed layer. The seed layer 3 will not function as a solar cell layer but rather for the epitaxial growth of a first solar cell layer 4. The thickness of the InP seed layer may be in the range of 50 nm to 1 µm.

A first solar cell is formed on the first engineered substrate, and on the first solar cell layer 4 a second solar cell layer 5 is epitaxially grown.

Furthermore, it is provided a second substrate 6 whereupon a third solar cell layer 7 and a fourth solar cell layer 8 are epitaxially grown. The second substrate 6 is preferably a bulk GaAs substrate, since this material is transparent to the wavelengths of the incoming solar light, that will correspond to the absorption wavelength of the solar cell layers 4 and 5. The second substrate 6 according to the shown example is polished on both (lower and upper) surfaces in order to facilitate the subsequently performed bonding (see below).

The four solar cell layers 4 - 8 show absorption maxima for incident solar light for different wavelengths. It should be noted that the first solar cell layer 4 becomes the bottom cell and the fourth solar cell layer 7 becomes the top cell in the finished multijunction solar cell device (see description below). According to the present example all of the four monocrystal solar cell layers 4 - 8 are formed by epitaxial growth. In principle, the material of the solar cell layers can be selected form III-V semiconductors of the group consisting of InGaAs, GaAS, AlGaAs, InGaP, InP and InGaAsP. For example, the first solar cell layer 4 may be comprised of InGaAs, the second solar cell layer 5 may be comprised of InGaP, InGaAsP or InP, the third solar cell layer 7 may be comprised of GaAsP or GaAs, and the fourth solar cell layer 8 may be comprised of InGaP or InAlAs. Appropriate tunnel junction layers may be provided between particular ones of the solar cell layers by deposition or growth on a respective solar cell layer.

As it is illustrated in Figure 1, the resulting wafer structures comprising the first base substrate 1 and the first two solar cell layers 4 and 5 and the second substrate 6 and second two solar cell layers 7 and 8, respectively, are bonded together. In the most preferred embodiment, the bonding is performed by direct bonding of the structures, or in other words molecular adhesion of the two faces in contact, without any bonding layers. Molecular adhesion is performed preferably under partial vacuum. Contacting and bonding can be performed at relatively high temperatures of about 400 °C to 600 °C and more preferably between 450 °C and 550 °C. Preferably, the contacting step is performed at room temperature followed by an annealing step reaching max temperature between 400° and 600°C, although it is not excluded to perform the contacting step at a higher temperature. This bonding step is crucial for the quality of the resulting multijunction solar cell and it is favourable to perform high-temperature bonding in order to achieve a high-quality bonding interface between the lower surface of the second substrate and the second solar cell layer 5 without significant defects.

Subsequently, the first base substrate 1 is detached from the seed layer 3 by means of the zipper layer 2, for example, the first engineered substrate is cleaved at the zipper layer 2 allowing the detachment of first base substrate 1 from the seed layer 3. For instance, the zipper layer 2 may be provided in form of a weakened layer formed by the implantation of ionic species, for example, hydrogen or helium ions. In this case, the first substrate 1 can be provided as a bulk InP substrate, the implantation through the main top surface of the bulk substrate forms the weakened layer 2 that creates the seed layer 3 and the first base substrate 1 respectively in the top portion and the bottom portion of the bulk substrate. Then detachment of the first base substrate 1 can be mediated by the application of mechanical forces to delaminate at the weakened layer formed by hydrogen or helium ions.

Moreover, residue of the base substrate and/or bonding layer and the seed layer 3 may be removed by etching and/or polishing, for example, in particular if the seed layer 3 shows poor electrical and/or thermal properties and could not be used in the subsequent device. It is noted that the detached first base substrate 1 can be recycled to form a new engineered substrate for the re-usage as a growth substrate for epitaxial layers.

The second substrate is insuring sufficient stability and rigidify to the structure, such that it is not mandatory to provide this structure onto a final substrate. However, in an optional approach, the thus obtained structure comprising two solar cell layers on either main surface of the second substrate 6 can be bonded to a base substrate (not shown in Figure 1). This bonding process may be performed by direct conductive bonding the first solar cell layer 4 to the base substrate or by means of a metallic bonding layer that is formed on the exposed surface of the first solar cell layer 4 or the base substrate before the bonding process. It is also possible to form a metallic bonding layer on the exposed surface of the first solar cell layer 4 and the base substrate, respectively. It is noted that the base substrate may function as a thermally and electrically conductive substrate. Particularly, the base substrate may be made of Cu or Al, in particular, made of an aluminium sheet stiff enough to provide support of the stacked solar cell layers. Other envisaged candidates for the base substrate comprise Si, such as doped silicon, Mo and W.

In the next step illustrated in Figure 1 the resulting structure is subject to some finish processing comprising the formation of a plurality of mesas comprising etched solar cell layers 7' and 8'. The formation of the mesas can be achieved by lithographic processing after the formation of an appropriately patterned photoresist and optionally formed anti-reflective coating.

All previously discussed embodiments are not intended as limitations but serve as examples illustrating features and advantages of the invention. It has to be understood that some or all of the above described features can also be combined in different ways. It has to be understood that some or all of the above described features can also be combined in different ways. In particular, it is possible according to the invention to form multijunction solar cells not only composed of 4 junctions (as generally disclosed in the previous embodiments) but also 2, 3, 5 or more.

## Claims

1. Method for manufacturing a multijunction solar cell device comprising the steps of
providing a first substrate;
providing a second substrate having a lower surface and an upper surface;
forming at least one first solar cell layer on the first substrate to obtain a first wafer structure;
forming at least one second solar cell layer on the upper surface of the second substrate to obtain a second wafer structure;
bonding the first wafer structure to the second wafer structure wherein the at least one first solar cell layer is bonded to the lower surface of the second substrate; and
removing the first substrate.

2. The method according to claim 1, wherein the first substrate is an engineered first substrate.

3. The method according to claim 2, wherein the first substrate comprises a zipper layer and a first seed layer and wherein the method comprises the steps of
a) detaching the first engineered substrate at the zipper layer; and
b) removing the first seed layer.

4. The method according to claim 3, wherein
the zipper layer is formed by an electromagnetic absorbing layer between a seed layer and a base layer of the first engineered substrate and detachment of the first engineered substrate is performed by laser lift-off; or
the zipper layer is a weakened layer and detachment of the first engineered substrate is performed by application of thermal or mechanical strain; or
the zipper layer is a porous layer;
the zipper layer represents a low bonding energy interface.

5. The method according to one of the preceding claims, further comprising polishing the upper and/or lower surface of the second substrate.

6. The method according to one of the preceding claims, further comprising forming a contact on the at least one first solar cell layer after detachment of the first substrate and/or forming a contact on the at least one second solar cell layer.

7. The method according to one of the claims 2 to 6, wherein the first engineered substrate comprises a sapphire substrate and the first seed layer comprises or consists of InP, InAs, GaSb, Ge or GaAs.

8. The method according to one of the preceding claims, wherein the at least one first solar cell layer comprises a first and a second layer on the first layer and/or the at least one second solar cell layer comprises a third and a fourth layer on the third layer.

9. The method according claim 8, wherein the first layer comprises or consists of GaInAs and/or the second layer comprises or consists of GalnAsP and/or the third layer comprises or consists of GaAs and/or the fourth layer comprises or consists of GaInP.

10. The method according to one of the preceding claims, wherein the step of bonding the first wafer structure to the second wafer structure is performed at room temperature followed by annealing treatment that is performed at a temperature of about 400 °C to about 600 °C, in particular, between 450 °C and 550 °C.

11. The method according one of the claims 2 to 10, wherein providing the first engineered substrate comprises
growing the seed layer on a seed substrate; and
transferring the seed layer to a sapphire substrate.

12. The method according one of the preceding claims, further comprising bonding a base substrate in particular, a base substrate made of Cu, Mo, W or Si or Al, in particular, aluminium sheet, to the at least one first solar cell layer after detachment of the first substrate.

13. Multijunction solar cell device obtainable by the method according to one of the preceding claims.

14. Intermediate semiconductor substrate for multijunction solar cell, comprising a substrate, in particular, a GaAs substrate;
a second solar cell layer formed on a lower surface of the substrate, a first solar cell layer formed on the second solar cell layer, a third solar cell layer formed on an upper surface of the substrate and a fourth solar cell layer formed on the third solar cell layer wherein the first layer comprises or consists of GaInAs and/or the second layer comprises or consists of GaInAsP and/or the third layer comprises or consists of GaAs and/or the fourth layer comprises or consists of GaInP.

15. The intermediate semiconductor substrate according to claim 14, further comprising
a further substrate comprising InP, in particular, an engineered substrate comprising InP, whereupon the first solar cell layer is formed.

16. The intermediate semiconductor substrate according to claim 14, further comprising a base substrate, in particular, a base substrate made of Cu, Mo, W or Si or Al, in particular aluminium sheet bonded to the first solar cell layer, in particular, by a conductive bonding layer.
